# FASCICULE DE BREVET EUROPEEN

(11) **EP 0 548 351 B1**
(45) Date de publication et mention de la délivrance du brevet: **25.11.1998**
(21) Numéro de dépôt: 92916200.6
(22) Date de dépôt: 10.07.1992
(51) Int. Cl.: H01L 21/285, H01L 21/60, H01L 29/41

(54) **PROCEDE DE FABRICATION DE CIRCUITS INTEGRES AVEC ELECTRODES JUXTAPOSEES**
VERFAHREN ZUR HERSTELLUNG INTEGRIERTER SCHALTUNGEN MIT NEBENEINANDER GEFORMTEN ELEKTRODEN
METHOD FOR PRODUCING INTEGRATED CIRCUITS HAVING ADJACENT ELECTRODES

(30) Priorité: 16.07.1991 FR 9108953
(43) Date de publication de la demande: 30.06.1993
(73) Titulaire: THOMSON-CSF SEMICONDUCTEURS SPECIFIQUES, 75008 Paris (FR)
(72) Inventeur: BLANCHARD, Pierre, F-92045 Paris-La Défense Cédex 67 (FR)
(74) Mandataire: Guérin, Michel
(86) Numéro de dépôt international: FR9200673
(87) Numéro de publication internationale: WO9302469

(56) Documents cités:
- EP-A- 209 425
- EP-A- 435 257
- IBM TDB, vol. 20, no. 4, septembre 1977, New York, pages 1430-1432; P.L. GARBARINO et al.: "Making charge coupled-devices"
- IBM TDB, vol. 20, no. 1, juin 1977, New York, pages 131-132; P.L. ARBARINO et al.: "Application of reactive ion etch in fabrication of high performance charge-coupled shift registers"

## Description

L'invention concerne les circuits intégrés.

Dans certaines applications, et on citera à titre d'exemple les dispositifs à transferts de charge, on a besoin de réaliser côte à côte des électrodes qui sont très proches l'une de l'autre mais qui ne se recouvrent pas trop pour ne pas créer une capacité parasite trop élevée entre les deux électrodes et, dans le cas de dispositifs photosensibles, pour que la photosensibilité ne soit pas réduite par ce recouvrement.

Par exemple, dans un registre à transfert de charges, des électrodes sont juxtaposées de manière qu'un paquet de charges stockées dans un substrat semiconducteur sous une électrode puisse être transféré sous une électrode adjacente par simple application de potentiels appropriés sur les électrodes. Si les électrodes ne sont pas suffisamment proches l'une de l'autre le transfert risque d'être incomplet. Mais pour réaliser des électrodes très rapprochées, les techniques existantes nécessitent en pratique de prévoir un recouvrement partiel (avec isolant intermédiaire) d'une électrode par l'autre.

Le brevet EP-A-0 209 425 décrit un procédé complexe pour éviter ce recouvrement. L'article IBM Technical Disclosure Bulletin Vol 20 N° 1 juin 1977 décrit un procédé avec électrodes de silicium et d'aluminium ne décrivant pas comment le recouvrement est évité ou n'est pas évité. Le brevet EP-A-0 435 257 décrit un procédé de réalisation de transistors, avec recouvrement des électrodes adjacentes.

L'invention propose un nouveau procédé de fabrication destiné à améliorer la réalisation de circuits intégrés devant avoir des électrodes juxtaposées très rapprochées.

Selon l'invention, on propose un procédé de fabrication de circuits intégrés ayant des électrodes juxtaposées très rapprochées dans lequel on dépose sur un substrat une première couche de silicium, on dépose au-dessus de cette couche une couche de masquage contre l'oxydation, on photograve la couche de masquage pour ouvrir celle-ci sur une faible largeur, on oxyde thermiquement sur toute son épaisseur la première couche de silicium là où elle n'est pas masquée, on enlève l'oxyde de silicium formé durant cette oxydation, ce qui forme un espace évidé ouvert vers le haut et délimité par la première couche de silicium là où elle n'a pas été oxydée et par la couche de masquage, on forme une couche isolante mince sur les flancs de la première couche le long des bords de l'espace évidé, on dépose une deuxième couche de silicium remplissant totalement cet espace, le rapport entre la largeur de l'espace évidé et l'épaisseur de la deuxième couche de silicium étant choisi suffisamment faible pour que l'épaisseur de silicium à l'intérieur de l'espace évidé soit supérieure à l'épaisseur à l'extérieur, caractérisé en ce qu'on enlève ensuite la totalité de l'épaisseur de la deuxième couche en dehors de l'espace évidé en laissant subsister du silicium dans tout cet espace.

La valeur maximale approximative du rapport entre la largeur de l'espace évidé et l'épaisseur de la deuxième couche de silicium est environ 2 à 4. Il est à noter que cette valeur est donnée surtout à titre indicatif, l'important étant le résultat final, c'est-à-dire la possibilité de former une surépaisseur dans l'espace évidé, telle que même après gravure de la totalité de l'épaisseur de la deuxième couche de silicium il reste dans l'ouverture une couche complète de silicium venant en contact avec les flancs isolés de la première couche. A titre d'exemple, avec les procédés actuels de dépôt de silicium polycristallin en phase vapeur à basse pression, on peut avoir une largeur d'ouverture de l'espace évidé jusqu'à environ 1,5 micromètres de large pour une épaisseur d'environ 1 micromètre de la deuxième couche de silicium.

La plupart du temps, l'invention sera utilisée pour des électrodes déposées au-dessus d'une couche isolante mince ; par conséquent dans ce cas il faut considérer que le substrat est un substrat de semiconducteur recouvert d'une couche isolante mince (oxyde de silicium et/ou nitrure de silicium de quelques centaines d'angströms d'épaisseur) ; la première couche de silicium est déposée sur cette couche isolante mince ; et si la deuxième électrode doit être déposée sur une couche isolante, on prévoit qu'après l'étape d'enlèvement de l'oxyde formé par oxydation de la première couche de silicium on reforme une couche isolante mince sur le substrat dans l'ouverture laissée libre.

Après formation des électrodes de la manière indiquée ci-dessus, on peut enlever la couche de masquage, totalement ou partiellement, ou alors on peut la laisser.

Le procédé selon l'invention permet d'aboutir à une structure intégrée à électrodes rapprochées, comprenant une première électrode et une deuxième électrode faites de portions d'une première couche de silicium de part et d'autre d'une troisième électrode faite d'une portion d'une deuxième couche de silicium, la troisième électrode étant séparée des première et deuxième électrodes par une couche mince isolante s'étendant le long d'un flanc oblique des première et deuxième électrodes et la pente du flanc oblique étant du type qui est obtenue si on oxyde localement la première couche de silicium sur toute son épaisseur, caractérisée en ce que le recouvrement entre les électrodes ainsi juxtaposées s'effectue essentiellement uniquement le long de ce flanc oblique.

Cette structure est particulièrement intéressante en ce que le recouvrement est très faible mais existe quand même : il en résulte qu'il n'y a pas de zone de substrat non contrôlée entre deux électrodes, ce qui est très important dans l'application principale de l'invention qui est la réalisation de dispositif à transfert de charges. Il en résulte aussi, dans le cas de dispositifs à transferts de charges dont les zones photosensibles sont situées sous les électrodes, que ces zones ne sont pas masquées sur leurs bords par une double épaisseur de silicium.

D'autres caractéristiques et avantages de l'invention apparaîtront à la lecture de la description détaillée qui suit et qui est faite en référence aux dessins annexés dans lesquels :

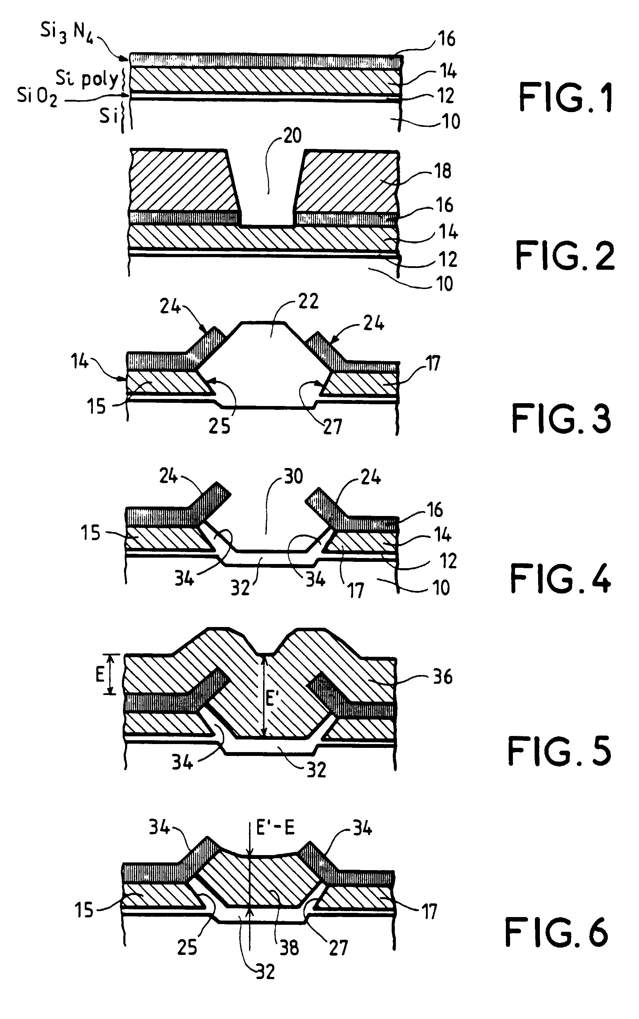

- les figures 1 à 6 représentent les étapes successives du procédé selon l'invention.

L'invention sera décrite principalement à propos d'électrodes juxtaposées recouvrant un semiconducteur avec interposition d'une couche mince isolante entre le semiconducteur et les électrodes. Ce cas est en effet le plus intéressant et trouve une application notamment dans le cas de dispositifs à transfert de charges, par exemple pour la réalisation des électrodes d'un registre à décalage (photosensible ou non).

On part d'un substrat 10 qui peut être constitué par un substrat de silicium 10 recouvert d'une couche isolante 12. La couche isolante sera le plus souvent un oxyde de silicium d'une centaine ou de quelques centaines d'angströms (10 angströms = 1 nanomètre) d'épaisseur, ou encore une superposition d'une couche mince d'oxyde de silicium de quelques dizaines d'angströms et d'une couche mince de nitrure de silicium de quelques dizaines à quelques centaines d'angströms.

On dépose uniformément sur le substrat ainsi constitué, c'est-à-dire sur la couche isolante 12, une première couche de silicium 14. Le dépôt est de préférence un dépôt par décomposition chimique (en général à partir de silane) en phase gazeuse, aboutissant à une couche de silicium polycristallin de quleques milliers d'angströms d'épaisseur.

Sur la première couche de silicium 14 on dépose uniformément une couche 16 de masquage contre l'oxydation du silicium, c'est-à-dire une couche apte à empêcher l'oxydation du silicium là où cette couche recouvre le silicium. La couche de masquage 16 est de préférence constituée essentiellement par du nitrure de silicium, avec éventuellement une fine couche d'oxyde de silicium (non représentée) entre la couche 14 et la couche 16, essentiellement pour améliorer la tenue de la couche 16 et pour faciliter ensuite la photogravure de cette couche 16.

La figure 1 représente la structure à ce stade de fabrication.

La première couche de silicium servira à former une première et une seconde électrodes; une troisième électrode sera formée entre les deux premières, aboutissant ainsi à la formation de trois électrodes juxtaposées comme on le désire.

On photograve (figure 2) la couche de nitrure 16 pour définir des ouvertures; chaque ouverture va diviser la première couche de silicium polycristallin 14 en deux électrodes distinctes 15 et 17 séparées par l'ouverture, la largeur de l'ouverture étant suffisante pour y loger ultérieurement une troisième électrode.

Pour cela, on recouvre la couche de nitrure 16 d'une résine photosensible 18 dans laquelle on définit par photolithographie une ouverture 20. Par attaque plasma, on ouvre la couche de nitrure 16 là où elle n'est pas protégée par la résine, de sorte qu'on obtient dans l'ouverture 20 une surface de silicium polycristallin apparente (ou éventuellement recouverte d'une fine couche d'oxyde de silicium). Il est à noter qu'on pourrait envisager d'autres procédés de gravure d'une ouverture dans le nitrure de silicium, pourvu qu'elle aboutisse à une ouverture de largeur relativement faible dans le nitrure. Les figures représentent des coupes dans le sens de la largeur de l'ouverture. La longueur n'a pas d'importance. La largeur de l'ouverture dans le nitrure est de préférence au plus égale à environ deux fois l'épaisseur d'une couche de silicium polycristallin qu'on déposera ultérieurement et qui servira à la constitution de la troisième électrode; en pratique la deuxième couche de silicium aura une épaisseur de l'ordre de 5000 angströms et la largeur de l'ouverture dans le silicium ne devrait alors pas dépasser environ 1 à 1,5 micromètre, de préférence 1 micromètre .

La résine est éliminée à ce stade, et on procède alors à une étape d'oxydation thermique, en présence d'oxygène ou plus souvent de vapeur d'eau, et à température élevée (de l'ordre de 1000°C). L'oxydation thermique est poursuivie jusqu'à oxydation de toute l'épaisseur de la couche de silicium 14 là où celle-ci n'est pas protégée par le nitrure.

On reconnaît sur la figure 3 la forme classique avec bec d'oiseau de l'oxyde de silicium 22 ainsi produit dans l'ouverture du nitrure. L'oxyde thermique produit est plus épais (environ 50% de plus) que la couche de silicium 14. Et la frontière entre l'oxyde et la partie de couche 14 non oxydée définit un flanc oblique 25, 27 des électrodes 15 et 17. Le flanc oblique des électrodes est tourné vers le haut. Enfin, les bords 24 de la couche 16 de nitrure sont soulevés par la croissance de l'oxyde 22.

On procède alors à une étape de désoxydation, c'est-à-dire qu'on attaque chimiquement le substrat jusqu'à disparition de la couche 22 (figure 4). Cette attaque évide un espace 30 ouvert vers le haut, défini par:
- en bas le substrat de silicium 10;
- à droite et à gauche respectivement les flancs des électrodes 15 et 17,
- en haut partiellement par les bords de nitrure 24 qui reposaient sur l'oxyde 22 et qui restent en surplomb;
- pour le reste, l'espace évidé 30 reste ouvert vers le haut entre les bords de nitrure 24 qui se font face l'un du côté de l'électrode 15, l'autre du côté de l'électrode 17.

On forme alors, de préférence par oxydation thermique du silicium, une couche mince isolante qui vient recouvrir d'une part le silicium du substrat au fond de l'espace évidé 30, et d'autre part les flancs des électrodes 15 et 17. Cette couche est désignée par 32 au fond de l'espace et par 34 sur les flancs des électrodes. La zone 32 n'est prévue que si l'électrode qui sera déposée ultérieurement doit être isolée du substrat.

On dépose alors une deuxième couche de silicium polycristallin 36, avec une épaisseur E suffisante pour que le silicium vienne non seulement combler tout l'espace évidé 30, mais encore qu'il forme une surépaisseur (épaisseur totale E') dans tout cet espace. Pratiquement, dans le cas d'un dépôt par décomposition chimique en phase gazeuse, cette surépaisseur se forme au dessus de tout l'espace 30 à partir du moment où l'épaisseur de la couche déposée est suffisante, c'est-à-dire supérieure à la moitié environ de la largeur de l'espace évidé, entre les flancs des électrodes 15 et 17.

La figure 5 représente la structure à ce stade de la fabrication.

Comme on le voit, grâce au nitrure de silicium 16 et grâce aux couches isolantes 32 et 34, la deuxième couche de silicium 36 est complètement isolée électriquement de la première à l'intérieur de l'espace évidé 30 qu'elle remplit.

L'étape suivante est une gravure uniforme du silicium de la deuxième couche (figure 6), sur une profondeur au moins égale à l'épaisseur E de cette couche mais inférieure à l'épaisseur E'. L'idéal serait d'enlever exactement la profondeur E, mais il est plus sûr d'attaquer sur une profondeur légèrement supérieure à E pour être sûr qu'il ne reste pas de silicium en dehors des espaces évidés 30.

Dans tout l'espace 30, il subsiste donc du silicium polycristallin, sur une épaisseur d'environ E'-E (qui est de l'ordre de l'épaisseur E ou un peu moins). Ce silicium constitue une électrode 38 placée entre les électrodes 15 et 17; elle est très proche de ces deux électrodes puisqu'elle en est séparée seulement par une couche mince isolante 34 qui peut être très fine (quelques dizaines d'angströms si on le désire) avec un recouvrement entre les électrodes qui est cependant très faible puisqu'il existe seulement le long des flancs obliques 25 et 27 des électrodes 15 et 17. Le recouvrement, faible, existe cependant grâce au flancs obliques, de sorte qu'il n'y a pas de zone de substrat non contrôlée comme ce serait le cas si des électrodes non recouvrantes étaient juxtaposées avec un interstice vertical entre elles. Ceci est particulièrement important pour les électrodes d'un dispositif à transfert de charges.

## Revendications

1. Procédé de fabrication de circuits intégrés ayant des électrodes juxtaposées très rapprochées dans lequel on dépose sur un substrat (10, 12) une première couche de silicium (14), on dépose au-dessus de cette couche une couche (16) de masquage contre l'oxydation, on photograve la couche de masquage pour ouvrir celle-ci sur une faible largeur (20), on oxyde thermiquement sur toute son épaisseur la première couche de silicium (14) là où elle n'est pas masquée, on enlève l'oxyde de silicium formé durant cette oxydation, ce qui forme un espace évidé (30) ouvert vers le haut et délimité par la première couche de silicium là où elle n'a pas été oxydée et par la couche de masquage, on forme une couche isolante mince (34) sur les flancs de la première couche le long des bords de l'espace évidé, on dépose une deuxième couche de silicium (36) remplissant totalement cet espace, le rapport entre la largeur de l'espace évidé et l'épaisseur (E) de la deuxième couche de silicium étant choisi suffisamment faible pour que l'épaisseur de silicium (E') à l'intérieur de l'espace évidé soit supérieure à l'épaisseur à l'extérieur, caractérisé en ce qu'on enlève ensuite la totalité de l'épaisseur (E) de la deuxième couche en dehors de l'espace évidé en laissant subsister du silicium (38) dans tout cet espace.

2. Procédé selon la revendication 1, caractérisé en ce que la valeur maximale approximative du rapport entre la largeur de l'espace évidé et l'épaisseur de la deuxième couche de silicium est environ 2 à 4.

3. Procédé selon l'une des revendications 1 et 2, caractérisé en ce que le substrat comprend un semiconducteur recouvert d'une couche isolante mince sur laquelle est déposée la première couche de silicium.

4. Procédé selon l'une des revendications 1 à 3, caractérisé en ce que, après l'étape d'enlèvement de l'oxyde formé par oxydation de la première couche de silicium, on reforme une couche isolante mince sur le substrat dans l'ouverture laissée libre par cet enlèvement.

5. Procédé selon l'une des revendications 1 à 4, caractérisé en ce que les électrodes sont les électrodes d'un dispositif à transfert de charges.

## Patentansprüche

1. Verfahren zur Herstellung integrierter Schaltungen mit sehr eng nebeneinanderliegenden Elektroden, bei dem auf ein Substrat (10, 12) eine erste Siliziumschicht (14) aufgebracht wird, dann auf diese Schicht eine Maskenschicht (16) gegen Oxidation aufgebracht wird, dann die Maskenschicht durch Fotogravur ausgeätzt wird, um sie über eine geringe Breite (20) zu öffnen, dann die erste Siliziumschicht (14) über ihre ganze Dicke thermisch dort oxidiert wird, wo sie nicht von der Maske bedeckt ist, dann das Siliziumoxid, das während dieser Oxidation entstanden ist, entfernt wird, wodurch sich ein freigelegter Raum (30) ergibt, der nach oben offen ist und durch die erste Siliziumschicht dort, wo sie nicht oxidiert wurde, und durch die Maskenschicht begrenzt ist, dann eine dünne isolierende Schicht (34) auf den Flanken der ersten Schicht entlang der Ränder des freigelegten Raums gebildet wird, dann eine zweite Siliziumschicht (36) abgeschieden wird, die diesen Raum vollkommen füllt, wobei das Verhältnis zwischen der Breite des freigelegten Raums und der Dicke (E) der zweiten Siliziumschicht ausreichend gering gewählt wird, damit die Siliziumdicke (E') in dem freigelegten Raum größer als die Dicke der Siliziumschicht außerhalb ist, dadurch gekennzeichnet, daß dann die ganze Dicke (E) der zweiten Schicht außerhalb des freigelegten Raums entfernt wird, wobei Silizium (38) in dem ganzen Raum verbleibt.

2. Verfahren nach Anspruch 1, dadurch gekennzeichnet, daß der angenäherte Höchstwert des Verhältnisses zwischen der Breite des freigelegten Raums und der Dicke der zweiten Siliziumschicht etwa 2 bis 4 beträgt.

3. Verfahren nach einem der Ansprüche 1 und 2, dadurch gekennzeichnet, daß das Substrat einen mit einer dünnen isolierenden Schicht bedeckten Halbleiter enthält und daß auf diese Schicht die erste Siliziumschicht aufgebracht wird.

4. Verfahren nach einem der Ansprüche 1 bis 3, dadurch gekennzeichnet, daß nach dem Verfahrensschritt der Entfernung des Oxids, das bei der Oxidation der ersten Siliziumschicht gebildet wurde, eine dünne isolierende Schicht auf das Substrat in der Öffnung aufgebracht wird, die durch diese Entfernung des Siliziumoxids freigegeben wurde.

5. Verfahren nach einem der Ansprüche 1 bis 4, dadurch gekennzeichnet, daß die Elektroden zu einer Ladungstransfervorrichtung gehören.

## Claims

1. Process for manufacturing integrated circuits having electrodes juxtaposed very close together, in which a first silicon layer (14) is deposited onto a substrate (10, 12), an oxidation-preventing masking layer (16) is deposited on top of this layer, the masking layer is photoetched in order to open up the latter over a small width (20), the first silicon layer (14) is thermally oxidised over its entire thickness at that place where it is not masked, the silicon oxide formed during this oxidation is removed, which forms an upwardly-open hollowed-out space (30) delimited by the first silicon layer at that place where it has not been oxidised and by the masking layer, a thin insulating layer (34) is formed on the side walls of the first layer along the edges of the hollowed-out space, a second silicon layer (36) totally filling this space is deposited, the ratio between the width of the hollowed-out space and the thickness (E) of the second silicon layer being chosen to be sufficiently small for the silicon thickness (E') inside the hollowed-out space to be greater than the thickness outside, characterized in that the totality of the thickness (E) of the second layer is then removed from outside the hollowed-out space, while allowing silicon (38) to remain in all this space.

2. Process according to Claim 1, characterised in that the approximate maximum value of the ratio between the width of the hollowed-out space and the thickness of the second silicon layer is roughly 2 to 4.

3. Process according to one of Claims 1 and 2, characterised in that the substrate comprises a semiconductor covered with a thin insulating layer onto which the first silicon layer is deposited.

4. Process according to one of Claims 1 to 3, characterised in that, after the step for removing the oxide formed by oxidation of the first silicon layer, a thin insulating layer is reformed on the substrate in the opening left free by this removal.

5. Process according to one of Claims 1 to 4, characterised in that the electrodes are the electrodes of a charge-coupled device.
